# EUROPEAN PATENT SPECIFICATION

(11) **EP 2 436 115 B1**
(45) Date of publication and mention of the grant of the patent: **16.01.2013**
(21) Application number: 10724358.6
(22) Date of filing: 25.05.2010
(51) Int. Cl.: H03J 5/00, H04N 7/173

(54) **CONTROL OVER COAX FOR TV SIGNAL RECEPTION DEVICES**
STEUERUNG ÜBER KOAX FÜR FERNSEHSIGNALEMPFANGSGERÄTE
COMMANDE SUR CÂBLES COAXIAUX POUR DISPOSITIFS DE RÉCEPTION DE SIGNAL DE TÉLÉVISION

(30) Priority: 25.05.2009 EP 09160985
(43) Date of publication of application: 04.04.2012
(73) Proprietor: Unitron, 8970 Poperinge (BE)
(72) Inventor: PAESSCHESOONE, Roel, 8970 Poperinge (BE); DEREU, Koen, 8432 Leffinge (BE); DELEU, Stephen, 9080 Beervelde (BE); BOUKAL, Petr, 54901 Nove Mesto nad Metuji (CZ)
(74) Representative: Sarlet, Steven Renaat Irène
(86) International application number: PCT/EP2010/057182
(87) International publication number: WO 2010/136465

(56) References cited:
- WO-A1-2006/035015
- WO-A2-96/32815
- JP-A- 8 294 107

## Description

### Technical field

The present invention relates to a TV signal distribution system for distributing received TV signals, e.g. received from antenna or cable, between a plurality of end-user TV sets and a method for programming at least one programmable filter device in such a TV signal distribution system.

### Background art

Since the 1980s, filter devices are on the market to make a selection of certain TV channels received from aerials, cable, satellite dish, ... In the beginning, the selection of the channels was hardwired in the factory and could not be altered in the field.

But in the 1990s, programmable filter devices came on the market with the same purpose. These circuits could be reprogrammed to serve different frequencies or new applications without replacing the device by a new filter. The device could be simply programmed by the installer on site. More detailed descriptions can be found in the patent GB2272341. Different types of programming in the field exist on the market.

A first type consists of products that have the programming interface on board. Each product has its own programming unit, which makes it always ready to be reprogrammed but has the higher cost per product as disadvantage. An example of this product is the 6600 from Johansson, described in EP1794883.

A second type consists of products that do not contain the programming unit, but have an extra interface on board to connect an external programming unit. This external programming unit is generally connected to the filter device only during installation and is being manipulated on site, meaning in the same room. In this way, cost savings are achieved as 1 programming unit can serve more programmable filter devices. An example of this product is the VS21 with the OK41 handset from manufacturer Wisi.

### Disclosure of the invention

It is an aim of the invention to provide a TV signal distribution system of the aforementioned type, in which the programming of the programmable filter devices can be facilitated.

This aim is achieved according to the invention by a TV signal distribution system showing the technical characteristics of the first independent claim.

It is another aim of the invention to provide an easier method for programming at least one programmable filter device in a TV signal distribution system which distributes received TV signals between a plurality of end-user TV sets.

This aim is achieved according to the invention by the method showing the steps of the second independent claim.

According to the invention the coaxial output interfaces which are present on the programmable filter devices for the purposes of the standard operation of the system, i.e. the connection of coaxial cables towards the end-user TV sets, are reused for the control signals exchanged with the programming unit. This means that a coaxial cable is used to connect the programming unit to the programmable filter device. This coaxial cable is part of the TV signal distribution system as it transports the TV signals, but it is also suited to transport the control signals for the programming of one or more of the programmable filter devices. In order to put/retrieve the control signals on/from the coaxial network, the programmable filter devices of the system of the invention are provided with an appropriate modem and an appropriate interface device is associated with the programming unit.

There are several advantages to this invention. A first advantage is the reuse of the existing interfaces on the programmable filter devices. A more important advantage is the reuse of the existing coaxial cable network that has been installed especially to transport the TV signals from programmable filter devices to the end-user TV sets. While in the prior art, the programming of the filter device had to be done in its vicinity, mostly in the same room with a short cable, the reuse of the coaxial network according to the invention opens up more possibilities to control the programmable filter devices remotely. For example, in the prior art, the installer often needed expensive measurement equipment to program and fine tune the filter device and then still needed to inspect the picture quality of the end-user TV on the user's premises. With the present invention, while the filter devices can be installed outside on the roof near the antenna, the programming unit can be connected to the coaxial network just before the coax enters the TV. This makes it easy for the installer as he can program and fine tune the filter circuit while looking at the picture quality on the end-user TV, avoiding the need for expensive measurement equipment and avoiding the need to climb on the roof each time to make an adjustment.

Another advantage is that multiple filter devices can be programmed together as they can all be connected to the same coaxial network. In this way the programming unit can have access to all filter circuits on the coax without having to connect and disconnect the programming unit.

The technology described herein can be implemented in the same way in other coaxial products for use in such TV signal distribution systems, which means that an appropriate modem and communication protocol for establishing the communication with the programming unit over part of the coaxial network are implemented in the coaxial product. In this way, a single programming unit can also be used to control these other coaxial products.

### Brief description of the drawings

The invention will be further elucidated by means of the following description and the appended drawings.
Figure 1 schematically shows a prior art system.
Figure 2 schematically shows another prior art system.
Figure 3 schematically shows a first preferred embodiment of a system according to the invention.
Figure 4 schematically shows a second preferred embodiment of a system according to the invention.
Figure 5 schematically shows a third preferred embodiment of a system according to the invention.

### Modes for carrying out the invention

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. The terms are interchangeable under appropriate circumstances and the embodiments of the invention can operate in other sequences than described or illustrated herein.

Moreover, the terms top, bottom, over, under and the like in the description and the claims are used for descriptive purposes and not necessarily for describing relative positions. The terms so used are interchangeable under appropriate circumstances and the embodiments of the invention described herein can operate in other orientations than described or illustrated herein.

The term "comprising", used in the claims, should not be interpreted as being restricted to the means listed thereafter; it does not exclude other elements or steps. It needs to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

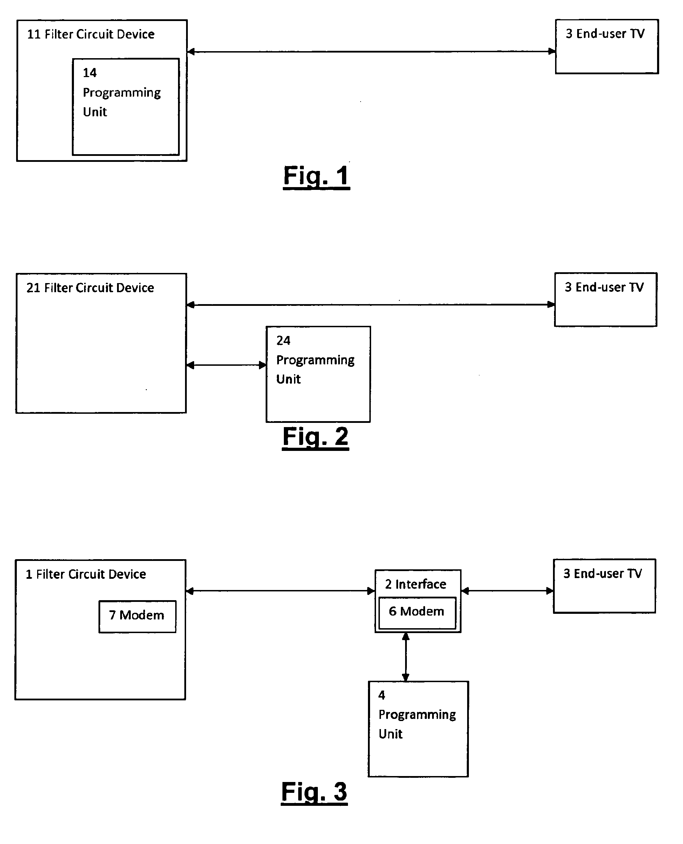

In the prior art TV signal distribution system shown in figure 1, a filter circuit device (11) which receives the TV signal from the antenna, is connected to the end-user TV (3) via a coaxial cable. A programming unit (14) is embedded in the filter circuit device (11). In this application, the installer programs the filter circuit device (11) by the onboard programming unit. After the programming, the TV signals run down to the TV set (3) via the coaxial cable.

In the prior art TV signal distribution system shown in figure 2, a filter circuit device (21) which receives the TV signal is connected to the end-user TV (3) via a coaxial cable. A programming unit (24) is connected externally to the filter circuit device (21) via a specific interface on this device. So the programming unit (24) and the filter circuit device (21) exchange communication signals via the separate interface on the device (21). In this application, the installer programs the filter circuit device (21) by the external programming unit (24) which is close to the filter circuit device (21). After the programming, the programming unit can be removed and the TV signals run down to the TV set (3) via the coaxial cable.

Figure 3 shows a possible embodiment of the invention. A filter circuit device (1) which receives the TV signal is connected to the end-user TV (3) via an interface device (2). The interconnections between the devices are made by coaxial cables. In one system, mostly more than 1 TV will be connected, but for the simplicity of the explanation, only 1 TV set is drawn (the same idea goes for Figures 1, 2, 4 and 5). A programming unit (4) is connected via the interface device (2) to the coaxial network. In this way, communication signals between the programming unit (4) and the filter circuit device (1) are transferred via the coaxial network. The programming unit and the filter circuit device (1) can respectively operate as a master device and a slave device, i.e. the communication signals are requests originating from the programming unit (4) and responses are given back by the filter circuit device (1). In this system, Frequency Shift Keying (FSK) is preferably selected as the communication protocol, as FSK has a number of advantages (good dynamic range, robustness against distortion, a number of integrated circuits on the market to support this protocol). But of course the invention can also be realized with other types of communication, like Amplitude Shift Keying (ASK), Phase Shift Keying (PSK), ...

With the TV signal distribution system of figure 3, the programming unit (4) can be used to program multiple filter circuit devices (1) which are connected to the coaxial network at the same time. For example, if one setting needs to be generally changed throughout the system, this can be done by sending the appropriate general control signal from the programming unit over the coaxial network. If it is desired to change the settings of one or a subset of the filter circuit devices (1), this can be done by providing each filter circuit device with a unique ID and including the ID(s) in the control signal which is sent out from the programming unit (4).

As shown in figure 3, the interface device (2) can be very simple and for example comprise 2 coaxial connectors and a modem (6) towards the programming unit (4) which couples the communication signals from the coax to the programming unit and vice versa. The programming unit (4) can for instance be connected to the interface (2) via USB.

The filter circuit device (1), herein also named programmable filter device, can be generally of the type described in EP1794883 which is incorporated herein by reference in its entirety. The technical features and operation of these filter circuit devices are known in the art and therefore need not be described in great detail here. In general, these type of devices comprise:
- a number of programmable filter circuits (not shown) for filtering a programmable spectrum of one or more TV channels from an input signal,
- at least one coaxial output interfaces (not shown) connected to the programmable filter circuits for connecting a network of coaxial cables for supplying the spectrum of one or more TV channels to the end-user TV sets, and
- a controller for setting the programmable filter circuits according to settings stored in a reprogrammable memory.

A difference with the filter circuit devices described in EP1794883 is that the user interface, previously necessary for programming the device, can be replaced by the interface system of the invention which reuses part of the coaxial network. To this end, in the filter circuit device (1) also a modem (7) is provided which couples the communication signals from the coax to their destination within the filter circuit device (1), e.g. the controller, which upon receipt of the control signals accordingly changes the settings in the programmable memory.

According to the invention, the communication signals are placed on the coaxial network at a frequency outside the band(s) which are currently used for transferring TV channels. In one embodiment, a predetermined frequency can be reserved for the communication signals, but more preferably a protocol is implemented where the most suitable frequency is dynamically detected for the communication signals, which can possibly be an empty spot within the TV channel band. Such a frequency detection protocol is known in the art and therefore needs no further explanation here.

The programming unit (4) can for example be a laptop computer provided with a software application for remotely programming filter devices (1), or any other thinkable programming unit.

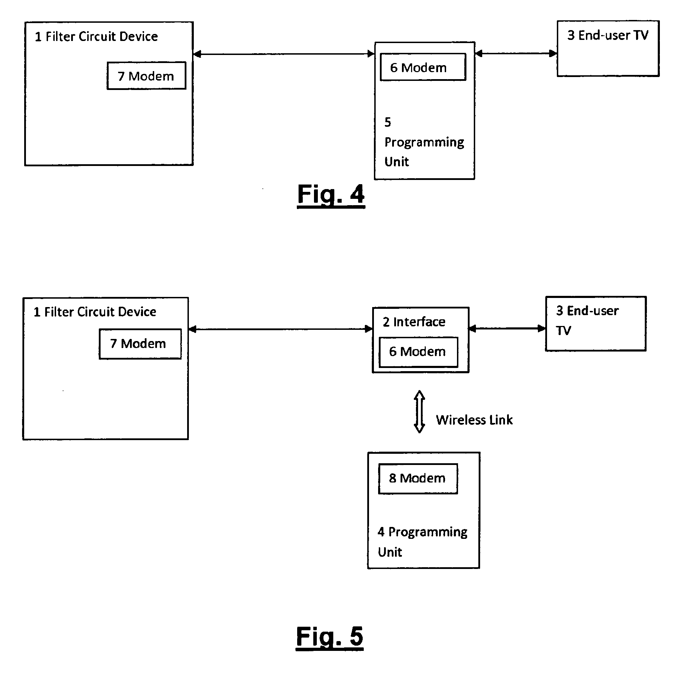

Another embodiment of the invention can be seen in Figure 4, where the basis is the same as in Figure 3 but where the interface and the programming unit are combined in a programming unit (5). In this embodiment, the programming unit (5) is intermediately placed between the filter device (1) and the TV set (3) for programming purposes.

Another possible embodiment of the invention can be seen in Figure 5 where the physical link in Figure 3 between the interface device (2) and the programming unit (4) can be replaced by a wireless link. In this embodiment, the interface device (2) and the programming unit (4) respectively have appropriate modems (6) and (8) for establishing the wireless link.

In a further alternative embodiment to Figure 3, the interface device (2) can have a modem (not shown) for coupling to the internet (via cable or DSL line) or a cellular network, with the programming unit (4) being a remote system for remote monitoring by the installer. The link can also be used for alarm signalling and maintenance.

In the Figures, abstraction has been made from the exact distance of the interface (2) to the filter circuit device (1) and the end-user TV (3). It is even part of the invention to be free where to connect the interface (2), it can be everywhere the coax network is available.

## Claims

1. TV signal distribution system for distributing received TV signals between a plurality of end-user TV sets, the system comprising at least one programmable filter device (1) and a programming unit (4, 5) for programming the programmable filter device, the programmable filter device comprising:
- a number of programmable filter circuits for filtering a spectrum of one or more TV channels from an input signal,
- at least one coaxial output interface connected to the programmable filter circuits for connecting a network of coaxial cables for supplying the spectrum of one or more TV channels to the end-user TV sets, and
- a controller for setting the programmable filter circuits according to settings stored in a reprogrammable memory,
the TV signal distribution system further comprising an interface system for connecting the programming unit (4, 5) to the programmable filter device (1) and exchanging control signals for programming the reprogrammable memory,
**characterised in that** the interface system comprises:
- a modem (7) in the programmable filter device (1) for coupling the control signals between the programmable filter device and the at least one coaxial output interface used for supplying the spectrum of one or more TV channels to the end-user TV sets, and
- an interface device (2) connectable to the network of coaxial cables and provided for coupling the control signals between the network and the programming unit (4, 5).

2. TV signal distribution system according to claim 1, **characterised in that** the modem (7) and the interface device (2) are provided for exchanging the control signals using frequency shift keying.

3. TV signal distribution system according to claim 1 or 2, **characterised in that** the modem (7) and the interface device (2) are provided for exchanging the control signals in a predetermined band outside the bands used for the TV channels.

4. TV signal distribution system according to claim 1 or 2, **characterised in that** the modem (7) and the interface device (2) are provided for dynamically detecting a frequency suitable for exchanging the control signals.

5. TV signal distribution system according to any one of the previous claims, **characterised in that** the interface device (2) comprises 2 coaxial connectors and a modem (6) towards the programming unit (4).

6. TV signal distribution system according to any one of the claims 1-4, **characterised in that** the interface device (2) and the programming unit (4) are provided for communicating with each other via a wireless link.

7. TV signal distribution system according to any one of the claims 1-4, **characterised in that** the interface device (2) is integrated into the programming unit (5).

8. TV signal distribution system according to any one of the claims 1-4, **characterised in that** the interface device (2) comprises a modem for coupling to the internet or a cellular network, with the programming unit (4) being a remote system for remote monitoring by an installer.

9. Method for programming at least one programmable filter device (1) in a TV signal distribution system which distributes received TV signals between a plurality of end-user TV sets, the programmable filter device comprising:
- a number of programmable filter circuits filtering a spectrum of one or more TV channels from an input signal,
- at least one coaxial output interface connected to the programmable filter circuits to which a network of coaxial cables are connected for supplying the spectrum of one or more TV channels to the end-user TV sets, and
- a controller which sets the programmable filter circuits according to settings stored in a reprogrammable memory,
the method comprising the steps of:
- providing an interface system for connecting a programming unit (4, 5) to the programmable filter device (1) and
- exchanging control signals for programming the reprogrammable memory between the programming unit (4, 5) and the programmable filter device (1) via the interface system,
**characterised in that** the control signals between the programming unit (4, 5) and the programmable filter device (1) are exchanged using part of the network of coaxial cables between an interface device (2) and a modem (7) in the programmable filter device (1), the interface device being connected to the network of coaxial cables and coupling the control signals between the network and the programming unit (4, 5), the modem (7) in the programmable filter device (1) coupling the control signals between the programmable filter device and the at least one coaxial output interface.

10. Method according to claim 9, **characterised in that** the modem (7) and the interface device (2) exchange the control signals using frequency shift keying.

11. Method according to claim 9 or 10, **characterised in that** the modem (7) and the interface device (2) exchange the control signals in a predetermined band outside the bands used for the TV channels.

12. Method according to claim 9 or 10, comprising the step of dynamically detecting a frequency suitable for exchanging the control signals between the modem (7) and the interface device (2).

13. Method according to any one of the claims 9-12, **characterised in that** the interface device (2) and the programming unit (4) communicate with each other via a wireless link.

14. Method according to any one of the claims 9-12, **characterised in that** the interface device (2) and the programming unit (4) communicate with each other via the internet or a cellular network.

## Patentansprüche

1. TV-Signal-Verteilungssystem zum Verteilen empfangener TV-Signale zwischen mehreren Endnutzer-TV-Geräten, wobei das System mindestens ein programmierbares Filtergerät (1) und eine Programmiereinheit (4, 5) zum Programmieren des programmierbaren Filtergerätes umfasst, wobei das programmierbare Filtergerät Folgendes umfasst:
- eine Reihe programmierbarer Filterkreise zum Filtern eines Spektrums von einem oder mehreren TV-Kanälen aus einem Eingangssignal,
- mindestens eine koaxiale Ausgangsschnittstelle, die mit den programmierbaren Filterkreisen verbunden ist, zum Verbinden eines Netzwerkes koaxialer Kabel zum Bereitstellen des Spektrums von einem oder mehreren TV-Kanälen an die Endnutzer-TV-Geräte, und
- einen Controller zum Einstellen der programmierbaren Filterkreise in Übereinstimmung mit Einstellungen, die in einem wiederprogrammierbaren Speicher gespeichert sind,
wobei das TV-Signal-Verteilungssystem ferner ein Schnittstellensystem zum Verbinden der Programmiereinheit (4, 5) mit dem programmierbaren Filtergerät (1) und Austauschen von Steuersignalen zum Programmieren des wiederprogrammierbaren Speichers umfasst,
**dadurch gekennzeichnet, dass** das Schnittstellensystem Folgendes umfasst:
- ein Modem (7) in dem programmierbaren Filtergerät (1) zum Koppeln der Steuersignale zwischen dem programmierbaren Filtergerät und mindestens einer koaxialen Ausgangsschnittstelle, die zum Bereitstellen des Spektrums von einem oder mehreren TV-Kanälen an die Endnutzer-TV-Geräte verwendet wird,
- ein Schnittstellengerät (2), das mit dem Netzwerk aus koaxialen Kabeln verbunden werden kann und zum Koppeln der Steuersignale zwischen dem Netzwerk und der Programmiereinheit (4, 5) vorgesehen ist.

2. TV-Signal-Verteilungssystem nach Anspruch 1, **dadurch gekennzeichnet, dass** das Modem (7) und das Schnittstellengerät (2) zum Austauschen der Steuersignale mittels Frequenzumtastung vorgesehen sind.

3. TV-Signal-Verteilungssystem nach Anspruch 1 oder 2, **dadurch gekennzeichnet, dass** das Modem (7) und das Schnittstellengerät (2) zum Austauschen der Steuersignale in einem vorbestimmten Band außerhalb der Bänder, die für die TV-Kanäle verwendet werden, vorgesehen sind.

4. TV-Signal-Verteilungssystem nach Anspruch 1 oder 2, **dadurch gekennzeichnet, dass** das Modem (7) und das Schnittstellengerät (2) zum dynamischen Erkennen einer Frequenz vorgesehen sind, die für das Austauschen der Steuersignale geeignet ist.

5. TV-Signal-Verteilungssystem nach einem der vorherigen Ansprüche, **dadurch gekennzeichnet, dass** das Schnittstellengerät (2) 2 koaxiale Verbinder und ein Modem (6) in Richtung der Programmiereinheit (4) umfasst.

6. TV-Signal-Verteilungssystem nach einem der Ansprüche 1 - 4, **dadurch gekennzeichnet, dass** das Schnittstellengerät (2) und die Programmiereinheit (4) zum Kommunizieren miteinander über eine drahtlose Verbindung vorgesehen sind.

7. TV-Signal-Verteilungssystem nach einem der Ansprüche 1 - 4, **dadurch gekennzeichnet, dass** das Schnittstellengerät (2) in die Programmiereinheit (5) integriert ist.

8. TV-Signal-Verteilungssystem nach einem der Ansprüche 1 - 4, **dadurch gekennzeichnet, dass** das Schnittstellengerät (2) ein Modem zum Koppeln an das Internet oder ein Mobilfunknetz umfasst, wobei es sich bei der Programmiereinheit (4) um ein entferntes System zur Fernüberwachung durch einen Installateur handelt.

9. Verfahren zum Programmieren von mindestens einem programmierbaren Filtergerät (1) in einem TV-Signal-Verteilungssystem, welches empfangene TV-Signale zwischen mehreren Endnutzer-TV-Geräten verteilt, wobei das programmierbare Filtergerät Folgendes umfasst:
- eine Reihe programmierbarer Filterkreise, welche ein Spektrum von einem oder mehreren TV-Kanälen aus einem Eingangssignal filtern,
- mindestens eine koaxiale Ausgangsschnittstelle, die mit den programmierbaren Filterkreisen verbunden ist, mit der ein Netzwerk koaxialer Kabel verbunden ist, um das Spektrum von einem oder mehreren TV-Kanälen an die Endnutzer-TV-Geräte bereitzustellen, und
- einen Controller, welcher die programmierbaren Filterkreise in Übereinstimmung mit Einstellungen, die in einem wiederprogrammierbaren Speicher gespeichert sind, einstellt,
wobei das Verfahren folgende Schritte umfasst:
- das Bereitstellen eines Schnittstellensystems zum Verbinden einer Programmiereinheit (4, 5) mit dem programmierbaren Filtergerät (1) und
- das Austauschen von Steuersignalen zum Programmieren des wiederprogrammierbaren Speichers zwischen der Programmiereinheit (4, 5) und dem programmierbaren Filtergerät (1) über das Schnittstellensystem,
**dadurch gekennzeichnet, dass** die Steuersignale zwischen der Programmiereinheit (4, 5) und dem programmierbaren Filtergerät (1) unter Verwendung eines Teils des Netzwerkes koaxialer Kabel zwischen einem Schnittstellengerät (2) und einem Modem (7) in dem programmierbaren Filtergerät (1) ausgetauscht werden, wobei das Schnittstellengerät mit dem Netzwerk koaxialer Kabel verbunden ist und die Steuersignale zwischen dem Netzwerk und der Programmiereinheit (4, 5) koppelt, wobei das Modem (7) in dem programmierbaren Filtergerät (1) die Steuersignale zwischen dem programmierbaren Filtergerät und mindestens einer koaxialen Ausgangsschnittstelle koppelt.

10. Verfahren nach Anspruch 9, **dadurch gekennzeichnet, dass** das Modem (7) und das Schnittstellengerät (2) die Steuersignale mittels Frequenzumtastung austauschen.

11. Verfahren nach Anspruch 9 oder 10, **dadurch gekennzeichnet, dass** das Modem (7) und das Schnittstellengerät (2) die Steuersignale in einem vorbestimmten Band außerhalb der Bänder, die für die TV-Kanäle verwendet werden, austauschen.

12. Verfahren nach Anspruch 9 oder 10, welches den Schritt des dynamischen Erkennens einer Frequenz umfasst, die zum Austauschen der Steuersignale zwischen dem Modem (7) und dem Schnittstellengerät (2) geeignet ist.

13. Verfahren nach einem der Ansprüche 9 - 12, **dadurch gekennzeichnet, dass** das Schnittstellengerät (2) und die Programmiereinheit (4) über eine drahtlose Verbindung miteinander kommunizieren.

14. Verfahren nach einem der Ansprüche 9 - 12, **dadurch gekennzeichnet, dass** das Schnittstellengerät (2) und die Programmiereinheit (4) miteinander über das Internet oder ein Mobilfunknetz kommunizieren.

## Revendications

1. Système de distribution de signaux de télévision pour distribuer des signaux de télévision reçus entre une pluralité de postes de télévision d'utilisateur final, le système comprenant au moins un dispositif de filtre programmable (1) et une unité de programmation (4, 5) pour programmer le dispositif de filtre programmable, le dispositif de filtre programmable comprenant :
- un nombre de circuits de filtre programmable pour filtrer un spectre d'un ou plusieurs canaux de télévision provenant d'un signal d'entrée,
- au moins une interface de sortie coaxiale connectée aux circuits de filtre programmable pour connecter un réseau de câbles coaxiaux pour fournir le spectre d'un ou plusieurs canaux de télévision aux postes de télévision d'utilisateur final, et
- un contrôleur pour régler les circuits de filtre programmable sur des paramètres stockés dans une mémoire reprogrammable,
le système de distribution de signaux de télévision comprenant en outre un système d'interface pour connecter l'unité de programmation (4, 5) au dispositif de filtre programmable (1) et échanger des signaux de commande pour programmer la mémoire reprogrammable,
**caractérisé en ce que** le système d'interface comprend :
- un modem (7) dans le dispositif de filtre programmable (1) pour coupler les signaux de commande entre le dispositif de filtre programmable et ladite au moins une interface de sortie coaxiale utilisée pour fournir le spectre d'un ou plusieurs canaux de télévision aux postes de télévision d'utilisateur final, et
- un dispositif d'interface (2) pouvant être connecté au réseau de câbles coaxiaux et prévu pour coupler les signaux de commande entre le réseau et l'unité de programmation (4, 5).

2. Système de distribution de signaux de télévision selon la revendication 1, **caractérisé en ce que** le modem (7) et le dispositif d'interface (2) sont prévus pour échanger les signaux de commande en recourant à la modulation par déplacement de fréquence.

3. Système de distribution de signaux de télévision selon la revendication 1 ou 2, **caractérisé en ce que** le modem (7) et le dispositif d'interface (2) sont prévus pour échanger les signaux de commande dans une bande prédéterminée en dehors des bandes utilisées pour les canaux de télévision.

4. Système de distribution de signaux de télévision selon la revendication 1 ou 2, **caractérisé en ce que** le modem (7) et le dispositif d'interface (2) sont prévus pour détecter dynamiquement une fréquence appropriée pour échanger les signaux de commande.

5. Système de distribution de signaux de télévision selon l'une quelconque des revendications précédentes, **caractérisé en ce que** le dispositif d'interface (2) comprend 2 connecteurs coaxiaux et un modem (6) en direction de l'unité de programmation (4).

6. Système de distribution de signaux de télévision selon l'une quelconque des revendications 1 - 4, **caractérisé en ce que** le dispositif d'interface (2) et l'unité de programmation (4) sont prévus pour communiquer l'un avec l'autre par l'intermédiaire d'une liaison sans fil.

7. Système de distribution de signaux de télévision selon l'une quelconque des revendications 1 - 4, **caractérisé en ce que** le dispositif d'interface (2) est intégré dans l'unité de programmation (5).

8. Système de distribution de signaux de télévision selon l'une quelconque des revendications 1 - 4, **caractérisé en ce que** le dispositif d'interface (2) comprend un modem pour le couplage à l'internet ou à un réseau cellulaire, l'unité de programmation (4) étant un système à distance pour le suivi à distance par un installateur.

9. Procédé pour programmer au moins un dispositif de filtre programmable (1) dans un système de distribution de signaux de télévision qui distribue des signaux de télévision reçus entre une pluralité de postes de télévision d'utilisateur final, le dispositif de filtre programmable comprenant :
- un nombre de circuits de filtre programmable filtrant un spectre d'un ou plusieurs canaux de télévision provenant d'un signal d'entrée,
- au moins une interface de sortie coaxiale connectée aux circuits de filtre programmable auxquels un réseau de câbles coaxiaux sont connectés pour fournir le spectre d'un ou plusieurs canaux de télévision aux postes de télévision d'utilisateur final, et
- un contrôleur qui règle les circuits de filtre programmable selon des paramètres stockés dans une mémoire reprogrammable,
le procédé comprenant les étapes consistant à :
- prévoir un système d'interface pour connecter une unité de programmation (4, 5) au dispositif de filtre programmable (1) et
- échanger des signaux de commande pour programmer la mémoire reprogrammable entre l'unité de programmation (4, 5) et le dispositif de filtre programmable (1) par l'intermédiaire du système d'interface,
**caractérisé en ce que** les signaux de commande entre l'unité de programmation (4, 5) et le dispositif de filtre programmable (1) sont échangés en recourant à une partie du réseau de câbles coaxiaux entre un dispositif d'interface (2) et un modem (7) dans le dispositif de filtre programmable (1), le dispositif d'interface étant connecté au réseau de câbles coaxiaux et couplant les signaux de commande entre le réseau et l'unité de programmation (4, 5), le modem (7) dans le dispositif de filtre programmable (1) couplant les signaux de commande entre le dispositif de filtre programmable et ladite au moins une interface de sortie coaxiale.

10. Procédé selon la revendication 9, **caractérisé en ce que** le modem (7) et le dispositif d'interface (2) échangent les signaux de commande en recourant à la modulation par déplacement de fréquence.

11. Procédé selon la revendication 9 ou 10, **caractérisé en ce que** le modem (7) et le dispositif d'interface (2) échangent les signaux de commande dans une bande prédéterminée en dehors des bandes utilisées pour les canaux de télévision.

12. Procédé selon la revendication 9 ou 10, comprenant l'étape consistant à détecter dynamiquement une fréquence appropriée pour échanger les signaux de commande entre le modem (7) et le dispositif d'interface (2).

13. Procédé selon l'une quelconque des revendications 9 - 12, **caractérisé en ce que** le dispositif d'interface (2) et l'unité de programmation (4) communiquent l'un avec l'autre par l'intermédiaire d'une liaison sans fil.

14. Procédé selon l'une quelconque des revendications 9 - 12, **caractérisé en ce que** le dispositif d'interface (2) et l'unité de programmation (4) communiquent l'un avec l'autre par l'intermédiaire de l'internet ou d'un réseau cellulaire.
